# EUROPÄISCHE PATENTSCHRIFT

(11) **EP 1 318 710 B1**
(45) Veröffentlichungstag und Bekanntmachung des Hinweises auf die Patenterteilung: **22.08.2007**
(21) Anmeldenummer: 02027132.6
(22) Anmeldetag: 04.12.2002
(51) Int. Cl.: H05K 9/00

(54) **Abschirmung für Gehäuse, zur Abschirmung gegen elektromagnetische Strahlung**
EMI-Shield for housing
Blindage d' un boîtier contre les ondes électromagnétiques

(30) Priorität: 05.12.2001 DE 10159778
(43) Veröffentlichungstag der Anmeldung: 11.06.2003
(73) Patentinhaber: SIEMENS AKTIENGESELLSCHAFT, 80333 München (DE)
(72) Erfinder: Szybalski, Michael, 12203 Berlin (DE)

(56) Entgegenhaltungen:
- EP-A- 1 001 670
- WO-A-00/21348

## Beschreibung

Durch im hohen Frequenzbereich betriebene Schaltungsanordnungen werden elektromagnetische Felder erzeugt, durch welche die Funktionsweise bzw. Wirkungsweise benachbart angeordneter Schaltungen beeinträchtig bzw. beeinflusst werden. Um die Auswirkungen der durch derartige elektromagnetische Felder - im folgendem auch als Störfelder bezeichnet - verursachten Störungen bzw. Beeinflussungen möglichst gering zu halten, werden hochfrequente Schaltungsanordnungen abgeschirmt. Dies wird beispielsweise dadurch erreicht, dass die hochfrequenten Schaltungsanordnungen in verschließbare und elektrisch leitende Gehäuse eingebaut werden, wobei die elektromagnetischen Störfelder in Folge des geschlossenen, elektrisch leitenden Gehäuses abgeleitet bzw. kompensiert werden. Die Effektivität solcher als Abschirmung eingesetzter Gehäuse hängt stark von ihrer elektrischen Geschlossenheit ab. Jeder Schlitz bzw. jede im Gehäuse vorhandene Öffnung verringert die Dämpfung des Gehäuses gegenüber elektromagnetischer Störstrahlung. Die im Sinne der elektromagnetischen Verträglichkeit (EMV) noch zulässigen Dimensionen von Öffnungen innerhalb der Gehäuse - auch als zulässige Schlitzlänge bezeichnet - steht im direkten Zusammenhang mit der Wellenlänge der erzeugten elektromagnetischen Störfelder, welche wiederum von der Frequenz abhängig ist, mit welcher die hochfrequenten Schaltungsanordnungen betrieben werden. Ein Gehäuse weist eine gute elektrische Geschlossenheit und damit eine gute Abschirmung gegen elektromagnetische Störstrahlung auf, - im folgenden auch als Hochfrequenz-Dichtigkeit bezeichnet - , wenn die größte im Gehäuse vorhandene Schlitzlänge kleiner als ein Zehntel der Wellenlänge der erzeugten, elektromagnetischen Störfelder ist.

Bekanntermaßen kann bei einem elektrisch leitenden Gehäuse - wie beispielsweise einem mehrere Leiterplatten mit hochfrequenten Schaltungsanordnungen aufweisenden Baugruppenträger - die Hochfrequenz-Dichtigkeit dadurch erhöht werden, dass die Anzahl der die Gehäuseteile des Baugruppenträgers miteinander verbindenden Verbindungspunkte erhöht wird. Steigt jedoch die Frequenz der Störfelder an, bzw. wird die Wellenlänge der erzeugten Störfelder kürzer, wird diese Art der Erhöhung der Hochfrequenz-Dämpfung sehr schnell unwirtschaftlich. In solchen Fällen kommen meist zusätzliche Elemente wie beispielsweise EMV-Federn zum Einsatz, welche jedoch nachteilig mit eine erhöhten wirtschaftlichen Aufwand verbunden sind.

In der Druckschrift WO 00/21348 ist beispielsweise eine Baugruppenträger beschrieben, bei dem zur Realisierung der Hochfrequenz-Dichtigkeit anstelle von EMV-Federn an den überlappenden Gehäuseteilen ineinander greifende Erhebungen und Ausnehmungen vorgesehen sind.

Desweiteren ist in EP 1 002 670 A2 ein HF-dichter, Eckprofile aufweisender Baugruppenträger offenbart, bei dem die Eckprofile im Anschlussbereich sowohl mit einer oberen als auch mit einer unteren Abdeckung des Baugruppenträgers jeweils mit einer Aussparung zur Aufnahme jeweils einer HF-Dichtung versehen sind, um die ansonsten vorhandenen Ritzen mit der HF-Dichtung zu verschließen.

Der Erfindung liegt somit die Aufgabe zugrunde, die Abschirmung bzw. Hochfrequenz-Dichtigkeit von elektrisch leitenden Gehäusen kostengünstig zu optimieren. Die Aufgabe wird durch eine Abschirmung gemäß den Merkmalen des Oberbegriffs des Patentanspruchs 1 durch dessen gekennzeichnende Merkmale gelöst.

Erfindungsgemäß besteht das elektromagnetisch abgeschirmte Gehäuse aus elektrisch leitfähigen Gehäuseteilen, wobei zumindest ein Teil der Gehäuseteile überlappend angeordnet ist. Der wesentliche Aspekt des erfindungsgemäßen Gehäuses besteht darin, dass jeweils eines der überlappenden Gehäuseteile eine längliche, kantenförmige Erhöhung aufweist und das jeweils andere Gehäuseteil derart mit einer elastischen Wirkung ausgestaltet ist, dass dieses elastische Gehäuseteil in Wirkverbindung mit dem die Erhöhung aufweisenden Gehäuseteil auf die Erhöhung gedrückt wird.

Der wesentliche Vorteil der erfindungsgemäßen Abschirmung besteht darin, dass durch Ausnutzung der elastischen Wirkung von Gehäuseteilen zur Erreichung einer guten Abschirmung elektronischer Schaltungen gegen elektromagnetische Störstrahlung keine zusätzlichen Dichtungselemente wie beispielsweise EMV-Federn erforderlich sind und folglich die Anzahl der Befestigungspunkte zwischen Gehäuseteilen reduziert und dadurch der wirtschaftliche Aufwand zur Realisierung einer optimalen Abschirmung minimiert werden kann.

Weitere vorteilhafte Ausgestaltungen der erfindungsgemäßen Abschirmung sind den weiteren Ansprüchen zu entnehmen.

Im folgenden wird die erfindungsgemäße Abschirmung anhand mehrerer Zeichnungen näher erläutert. Dabei zeigen
- FIG 1: ein zur Abschirmung von elektromagnetischen Störfeldern vorgesehenes, elektrisch leitendes Gehäuse in Form eines Baugruppenträgers,
- FIG 2 und 3: jeweils Detaildarstellungen von unterschiedlichen Ausgestaltungsvarianten der erfindungsgemäßen Abschirmung.

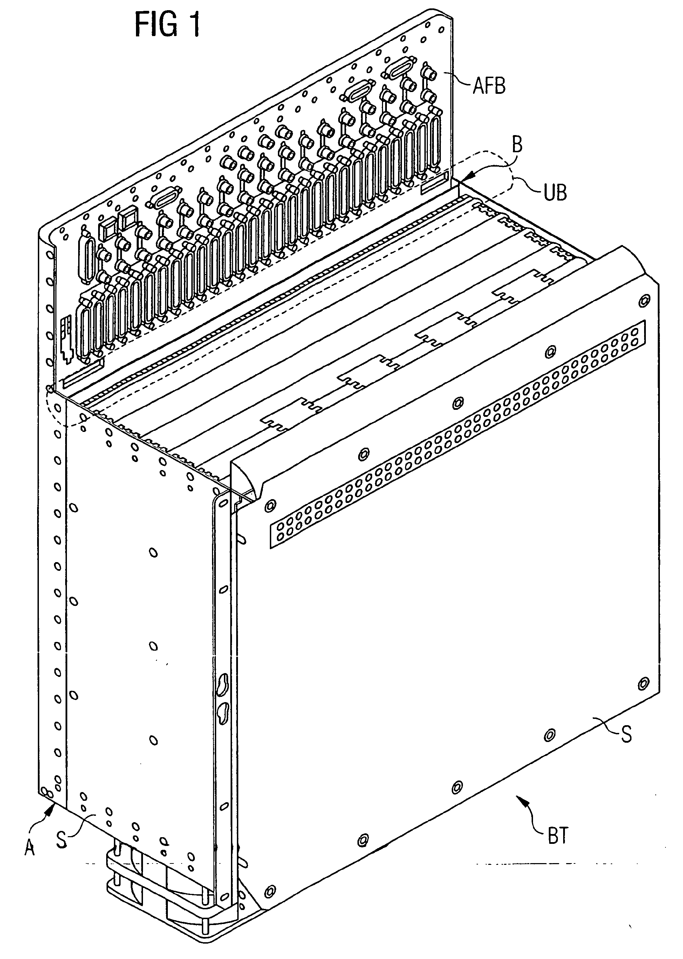

FIG 1 zeigt ein elektrisch leitendes Gehäuse in Form eines Baugruppenträgers BT in welchen beispielsweise mehrere Leiterplattenplatten - nicht dargestellt - mit integrierten, im hohen Frequenzbereich betriebene Schaltungsanordnungen angeordnet sind. Dieser Baugruppenträger BT kann beispielsweise in elektrischen Vermittlungseinrichtungen zur Steuerung von Sprach- und Datenverkehr in aktuellen Telekommunikationsnetzen eingesetzt werden. Der dargestellte Baugruppenträger BT ist aus mehreren Seitenwänden S zusammengefügt, welche zum Teil aus Strangpressprofilen gebildet sind.

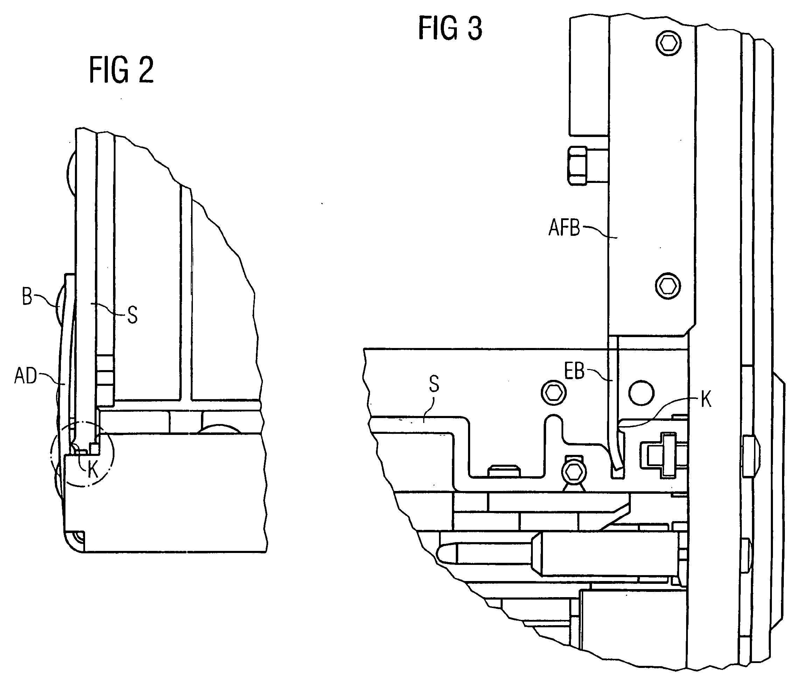

In FIG 2 ist ein Teil des in FIG 1 dargestellten Baugruppenträgers BT vergrößert dargestellt. Der vergrößerte Bereich und dessen Betrachtungsrichtung ist in FIG 1 durch den Pfeil A verdeutlicht. FIG 2 zeigt einen Ausschnitt des Bereichs der Überlappung der hinteren Baugruppenträgerabdeckung. In diesem Bereich ist ein als Strangpressprofil ausgebildetes hinteres Seitenteil S angeordnet, welches eine länglich ausgebildete bzw. quer über das hintere Seitenteil S verlaufende, dreieckige Erhöhung K aufweist, über welche eine hintere Baugruppenträgerabdeckung AD bei der Montage aufgespreizt wird. Erfindungsgemäß wird die hintere Baugruppenträgerabdeckung AD in der Art und Weise am hinteren Seitenteil S befestigt - z.B. mit Hilfe eines Befestigungselementes B -, daß die hintere Baugruppenträgerabdeckung AD über diese längliche Erhöhung K gebogen wird. Durch die Wirkverbindung - in FIG 2 durch einen strichliierten Kreis verdeutlicht - der hinteren Baugruppenträgerabdeckung AD mit der Erhöhung K wird über die ganze Länge der Erhöhung K - welche sich quer über das hintere Seitenteil S erstreckt - ein elektrischer Kontakt hergestellt. Im Bereich der Wirkverbindung ist somit der Baugruppenträger BT gegen elektromagnetische Störfelder abgeschirmt bzw. abgedichtet.

FIG 3 zeigt in einer vergrößerten Darstellung eine weitere Ausgestaltungsvariante der erfindungsgemäßen Abschirmung. Die Betrachtungsrichtung des vergrößerten Bereichs ist in FIG 1 durch den Pfeil B verdeutlicht. FIG 3 zeigt ein als Strangpressprofil ausgestaltetes Seitenteil S der oberen Gehäuseabdeckung des Baugruppenträgers BT. Erfindungsgemäß ist das Strangpressprofil S mit einer länglich ausgebildeten Erhöhung K versehen. Die Erhöhung K des Strangpressprofils S steht in Wirkverbindung mit einem elastisch ausgestalteten Blech EB, welches Bestandteil einer Anschlussfeldblende AFB des Baugruppenträgers BT ist. Das Strangpressprofil S steht im zusammengefügten Zustand des Baugruppenträgers BT in der Art und Weise mit der Anschlussfeldblende AFB und dem damit verbundenen elastischen Blech EB in Wirkverbindung, dass das elastische Blech EB um die Erhöhung K gebogen ist, so daß das elastische Blech EB und das Strangpressprofil S fest ineinander verkeilt sind, und somit stabil in elektrisch leitender Wirkverbindung stehen. Bei der in FIG 3 dargestellten Ausgestaltungsvariante ist das elastische Blech EB der Anschlussfeldblende AFB über einen länglichen Bereich - in FIG 1 durch einen strichliierten Kreis UB verdeutlicht - über die Erhöhung K gebogen, wodurch eine länglich ausgestaltete elektrische Verbindung hergestellt wird. Im Bereich dieser Wirkverbindung ist der Baugruppenträger BT gegen elektromagnetische Störfelder abgeschirmt bzw. abgedichtet.

Durch die erfindungsgemäße Gehäuseabschirmung kann auf den Einsatz zusätzlicher Elemente bzw. Befestigungselemente wie beispielsweise EMV-Federn verzichtet bzw. die Anzahl der die Verbindung zwischen zwei überlappenden Gehäuseteilen realisierenden Befestigungspunkte reduziert werden, wobei insgesamt der konstruktive und somit wirtschaftliche Aufwand reduziert werden kann.

## Patentansprüche

1. Elektromagnetisch abgeschirmtes Gehäuse (BT), bestehend aus elektrisch leitfähigen Gehäuseteilen (S), zur Abschirmung gegen elektromagnetische Strahlung,
wobei zumindest ein Teil der Gehäuseteile (S, AD, EB, AFB) überlappend angeordnet ist,
**dadurch gekennzeichnet,**
**daß** jeweils eines der überlappenden Gehäuseteile (S) eine länglich ausgebildete, kantenförmige Erhöhung (K) aufweist, daß das jeweils andere Gehäuseteil (AD, EB, AFB) derart mit einer elastischen Wirkung ausgestaltet ist, daß dieses elastische Gehäuseteil (AD, EB, AFB) in Wirkverbindung mit dem die Erhöhung (K) aufweisenden Gehäuseteil (S) auf die Erhöhung (K) gedrückt wird.

2. Elektromagnetisch abgeschirmtes Gehäuse nach Anspruch 1,
**dadurch gekennzeichnet,**
**daß** die elastische Wirkung des Gehäuseteils (AD, EB, AFB) durch eine Biegekante erreicht wird.

3. Elektromagnetisch abgeschirmtes Gehäuse nach Anspruch 1 oder 2,
**dadurch gekennzeichnet,**
**daß** die Gehäuseteile (S, AD, EB, AFB) Seitenwände eines Baugruppenträgers (BT) repräsentieren.

4. Elektromagnetisch abgeschirmtes Gehäuse nach einem der vorherigen Ansprüche,
**dadurch gekennzeichnet,**
**daß** das die kantenförmige Erhöhung (K) aufweisende Gehäuseteil (S) als Strangpressprofil ausgestaltet ist.

## Claims

1. Electromagnetically shielded housing (BT), consisting of electrically conductive housing components (S), for shielding against electromagnetic radiation,
whereby at least one part of the housing components (S, AD, EB, AFB) is arranged in an overlapping fashion,
**characterised in that**
in each case one of the overlapping housing components (S) has an elongated, edge-shaped raised section (K),
the other housing component (AD, EB, AFB) in each case is implemented in such a manner with an elastic action that this elastic housing component (AD, EB, AFB) is pressed onto the raised section (K) in an operational connection with the housing component (S) having the raised section (K).

2. Electromagnetically shielded housing as claimed in claim 1,
**characterised in that**
the elastic action of the housing component (AD, EB, AFB) is achieved by a bending edge.

3. Electromagnetically shielded housing as claimed in claim 1 or 2,
**characterised in that**
the housing components (S, AD, EB, AFB) represent side walls of a subrack (BT).

4. Electromagnetically shielded housing as claimed in one of the preceding claims,
**characterised in that**
the housing component (S) having the edge-shaped raised section (K) is implemented as an extruded section.

## Revendications

1. Boîtier (BT) blindé de façon électromagnétique, constitué de parties de boîtier (S) électroconductrices, pour le blindage contre le rayonnement électromagnétique,
au moins une partie des parties de boîtier (S, AD, EB, AFB) étant disposée en se chevauchant,
**caractérisé**
**en ce que** respectivement une des parties de boîtier (S) se chevauchant présente une élévation (K) de conception allongée et en forme de bord
**en ce que** l'autre partie de boîtier (AD, EB, AFB) respective est conçue avec un effet élastique de telle sorte que cette partie de boîtier (AD, EB, AFB) élastique est appuyée sur l'élévation (K), en liaison active avec la partie de boîtier (S) présentant l'élévation (K).

2. Boîtier blindé de façon électromagnétique selon la revendication 1, **caractérisé en ce que**
l'effet élastique de la partie de boîtier (AD, EB, AFB) est obtenu par un bord de pliage.

3. Boîtier blindé de façon électromagnétique selon la revendication 1 ou 2,
**caractérisé en ce que**
les parties de boîtier (S, AD, EB, AFB) représentent des parois latérales d'un châssis d'ensembles (BT).

4. Boîtier blindé de façon électromagnétique selon l'une quelconque des revendications précédentes,
**caractérisé en ce que**
la partie de boîtier (S) présentant l'élévation (K) en forme de bord est conçue comme un profilé extrudé.
